# EUROPÄISCHE PATENTSCHRIFT

(11) **EP 2 396 832 B1**
(45) Veröffentlichungstag und Bekanntmachung des Hinweises auf die Patenterteilung: **30.03.2016**
(21) Anmeldenummer: 10701548.9
(22) Anmeldetag: 29.01.2010
(51) Int. Cl.: H01L 33/62, H01L 33/48, H01L 33/52, H01L 23/495, H01L 21/48, H01L 23/00, H01L 23/31, H01L 33/54

(54) **VERKAPSELTE OPTOELEKETRONISCHE HALBLEITERANORDNUNG MIT LÖTSTOPPSCHICHT UND ENTSPRECHENDES VERFAHREN**
ENCAPSULATED OPTO-ELECTRONIC SEMICONDUCTOR ARRANGEMENT HAVING SOLDER STOP LAYER AND CORRESPONDING METHOD
DISPOSITIF SEMI-CONDUCTEUR OPTOÉLECTRONIQUE ENCAPSULÉ À COUCHE D'ARRÊT BRASÉE, ET PROCÉDÉ CORRESPONDANT

(30) Priorität: 12.02.2009 DE 102009008738
(43) Veröffentlichungstag der Anmeldung: 21.12.2011
(73) Patentinhaber: OSRAM Opto Semiconductors GmbH, 93055 Regensburg (DE)
(72) Erfinder: ZITZLSPERGER, Michael, 93047 Regensburg (DE); SPERL, Matthias, 93053 Regensburg (DE)
(74) Vertreter: Epping - Hermann - Fischer
(86) Internationale Anmeldenummer: PCT/EP2010/051116
(87) Internationale Veröffentlichungsnummer: WO 2010/091967

(56) Entgegenhaltungen:
- EP-A1- 1 153 792
- EP-A1- 1 357 595
- EP-A2- 0 684 641
- US-A- 5 973 337
- US-B1- 6 649 832
- US-B2- 7 109 067
- US-B2- 7 109 067

## Beschreibung

Die vorliegende Erfindung betrifft eine Halbleiteranordnung sowie ein Verfahren zum Herstellen einer Halbleiteranordnung.

Für die Herstellung von Halbleiteranordnungen werden häufig Leiterrahmen, so genannte Leadframes, verwendet. Ein Leadframe besteht aus einem metallischen blechförmigen Halbzeug, in dem durch Stanzen oder Ätzen einzelne voneinander getrennte Leiterabschnitte teilweise vorgefertigt werden, die zumindest teilweise mit einem äußeren Bereich des Leadframes verbunden sind. Der Begriff Leadframe, Leiterrahmen, ergibt sich daher, dass zu einem späteren Zeitpunkt die einzelnen Leiterabschnitte durch Stanzen, Ätzen oder Sägen aus dem Rahmen heraus vereinzelt werden. Als Material wird in der Regel Kupferblech verwendet, das beispielsweise mit einer Nickel- und Goldschicht versehen wird, um einen zuverlässigen Lötkontakt zu ermöglichen.

Bei der Herstellung von bekannten Halbleiteranordnungen wird häufig mindestens ein Halbleiterchip mechanisch und elektrisch mit den vorgesehenen elektrischen Leiterabschnitten verbunden. Nachfolgend wird der Chip und zumindest ein Teil von jedem Leiterabschnitt mit einer Kapselmasse umkapselt. Die elektrischen Leiterabschnitte ragen dann zumindest teilweise aus der Kapselmasse heraus, um sie beispielsweise auf einer Platine oder einer anders gearteten Kontaktanordnung anzuordnen. Eine derartige Anordnung erfolgt in der Regel mittels eines Lötverfahrens. Da die Kapselmasse häufig mit geringer Adhäsion auf der Oberfläche der Leiterabschnitte aufliegt, entstehen Spalte, durch die beim Auflöten der Halbleiteranordnung auf einer Leiterplatte mittels Kapillarkräfte Flussmittel und Lot in die Halbleiteranordnung eindringen. Das Lötzinn gelangt dabei auf die Oberfläche des Leiterrahmens, wo es zu Schäden führen kann. Erfolgt ein ungewünschter Kontakt zu dem innerhalb der Verkapselung angeordneten Bonddrahtes, so kann dies zu Schädigungen durch Versprödungen führen. Diese Gefahr besteht insbesondere dann, wenn als Kapselmasse Silikon verwendet wird.

In der Druckschrift US 5,973,337 A ist ein Halbleiterbauteil mit einem transparenten Verguss angegeben.

Die Druckschrift EP 1 153 792 A1 betrifft eine Leuchtenanordnung mit mehreren LED's.

Eine Halbleiterbauteilhausung mit einem Harz-beschichteten Kern findet sich in der Druckschrift EP 1 357 595 A1.

Eine Beschreibung eines oberflächenmontierbaren Gehäuses ist in der Druckschrift US 6,649,832 gegeben.

Aufgabe der Erfindung ist es nunmehr, ein Verfahren zur Herstellung einer Halbleiteranordnung und eine Halbleiteranordnung anzugeben, wobei die Möglichkeit zum Eindringen von Lötzinn in die Verkapselung zuverlässig verhindert ist.

Diese Aufgabe wird erfindungsgemäß durch die in den nebengeordneten Ansprüchen angegebenen Maßnahmen gelöst, wobei weiterführende vorteilhafte Ausgestaltungen in den untergeordneten Ansprüchen angegeben sind. Durch das Vorsehen einer Lötstoppschicht auf der Leiteranordnung, auf der zumindest ein Halbleiterelement befestigt und elektrisch leitend verbunden ist und eine Kapselmasse das Halbleiterelement derart abdeckt, dass sie an der Lötstoppschicht zumindest teilweise anliegt, ist verhindert, dass Lötzinn in dem Bereich, in dem die Kapselmasse an die Lötstoppschicht anliegt, Lötzinn in die Kapselmasse eintritt, da sie von der Lötstoppschicht zurückgehalten wird.

Durch das Vorsehen einer Vertiefung innerhalb der Leiteranordnung ist es ermöglicht, eine flache dicht gekapselte Halbleiteranordnung herzustellen.

Wird als Lötstoppschicht ein Lötstopplack vorgesehen, ergibt sich eine stärkere Adhäsion zwischen der Kapselmasse und der Leiteranordnung. Nachfolgend wird die Erfindung unter Bezugnahme auf die Zeichnung anhand von Ausführungsbeispielen erläutert.
Gemäß zumindest einer Ausführungsform der Halbleiteranordnung weist die Leiteranordnung einander gegenüberliegende Oberseiten und Unterseiten auf. Die Oberseite und die Unterseite sind jeweils stellenweise von der Lötstoppschicht bedeckt. Die Lötstoppschicht erstreckt sich also auf beide Hauptseiten der Leiteranordnung. Das eine oder die mehreren Halbleiterelemente sind bevorzugt ausschließlich an der Oberseite angebracht.

Gemäß einer Ausführungsform der Halbleiteranordnung ist die Leiteranordnung mehrteilig ausgeführt. Zum Beispiel umfasst die Leiteranordnung mindestens zwei separate Abschnitte, die nicht durch ein zusammenhängendes Material der Leiteranordnung verbunden sind. Eine mechanische Verbindung zwischen den Abschnitten erfolgt beispielsweise über eine insbesondere strahlungsdurchlässige Kapselmasse, die das Halbleiterelement und wenigstens einen Teil der Leiteranordnung überdeckt. Elektrisch sind die Abschnitte der Leiteranordnung bevorzugt voneinander isoliert, von einer elektrischen Verbindung über das Halbleiterelement selbst abgesehen.
Gemäß zumindest einer Ausführungsform der Halbleiteranordnung ist die Lötstoppschicht eine einzige, durchgängig miteinander verbundene Schicht, insbesondere bezogen auf je einen der Abschnitte der Leiteranordnung.

Gemäß einer Ausführungsform der Halbleiteranordnung weist die Leiteranordnung Anschlussflächen auf. Die Anschlussflächen sind zu einer Anbringung und elektrischen Kontaktierung des Halbleiterelements sowie zu einer externen elektrischen und/oder mechanischen Kontaktierung der Halbleiteranordnung vorgesehen. Die Anschlussflächen zur externen Kontaktierung sowie die Anschlussflächen zur Kontaktierung des Halbleiterelements befinden sich bevorzugt an einander gegenüberliegenden Seiten der Leiteranordnung.

Gemäß einer Ausführungsform der Halbleiteranordnung sind alle Anschlussflächen von der Lötstoppschicht vollständig umrandet. Mit anderen Worten existiert insbesondere um jede der Anschlussflächen herum an einer Oberfläche der Leiteranordnung ein geschlossener Pfad eines Materials der Lötstoppschicht. Der geschlossene Pfad beziehungsweise die Umrandung kann sich vollständig an einer der Hauptseiten der Leiteranordnung befinden. Ebenso ist es möglich, dass sich der geschlossene Pfad um die oder eine der Anschlussflächen sowohl auf die Oberseite und die Unterseite der Leiteranordnung erstreckt, die Anschlussfläche also auch bis an eine Stirnseite reichen kann.
Gemäß zumindest einer Ausführungsform der Halbleiteranordnung sind die Anschlussflächen an der Unterseite der Leiteranordnung nicht von der Kapselmasse überdeckt. Mit anderen Worten steht ein Material, durch das die Anschlussflächen gebildet sind, nicht in physischem Kontakt mit der Kapselmasse. Bevorzugt ist den Anschlussflächen an der Unterseite, in einer Richtung senkrecht zu den Anschlussflächen, kein Material der Kapselmasse nachgeordnet. Die Anschlussflächen an der Oberseite können demgegenüber vollständig von der Kapselmasse überdeckt sein.

Gemäß zumindest einer Ausführungsform der Halbleiteranordnung erstreckt sich die Lötstoppschicht über Stirnseiten der Leiteranordnung hinweg, wobei die Lötstoppschicht, in einem Querschnitt gesehen, stellenweise U-förmig ausgebildet ist. Stirnseiten sind dabei solche Oberflächen der Leiteranordnung, die die Oberseite mit der Unterseite verbinden. Mit anderen Worten sind die Stirnseiten teilweise oder vollständig von der Lötstoppschicht bedeckt oder mit dieser beschichtet.

Darüber hinaus wird ein Verfahren zur Herstellung einer Halbleiteranordnung angegeben. Mit dem Verfahren wird insbesondere eine Halbleiteranordnung, wie in Verbindung mit einer oder mehrerer der genannten Ausführungsformen angegeben, hergestellt. Merkmale für das Verfahren sind daher auch für die Halbleiteranordnung offenbart und umgekehrt.

Gemäß zumindest einer Ausführungsform des Verfahrens werden die Anschlussbereiche mit mindestens einer metallischen Schicht versehen. Die Schicht wird bevorzugt nach dem Aufbringen der Lötstoppschicht aufgebracht. Bei dem Aufbringen der metallischen Schicht kann die Lötstoppschicht als Maske dienen. Insbesondere ist die Lötstoppschicht elektrisch isolierend und die metallische Schicht wird zum Beispiel galvanisch aufgebracht, wobei die Lötstoppschicht während des Aufbringens der metallischen Schicht unbeschichtet bleibt.

Gemäß zumindest einer Ausführungsform des Verfahrens wird die Lötstoppschicht strukturiert auf der Leiteranordnung aufgebracht und anschließend ausgehärtet und/oder getrocknet. Zum Beispiel wird die Lötstoppschicht mittels eines Sprühens, Druckens, Siebdruckens, Vorhangießens oder mittels Walzenauftragung aufgebracht.

Gemäß zumindest einer Ausführungsform des Verfahrens verbleibt die Lötstoppschicht nach dem Aushärten und/oder Trocknen vollständig auf der Leiteranordnung. Vollständig auf der Leiteranordnung verbleiben schließt nicht aus, dass Teile der Lötstoppschicht entfernt werden, die sich über Bereichen der Leiteranordnung befinden, die ebenfalls entfernt werden, zum Beispiel bei einem Vereinzelungsprozess der Leiteranordnung aus einem Leadframe oder aus einem Leiterrahmenverbund heraus, etwa durch ein Sägen.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

Es zeigen:
- Figuren 1, 2, 4 bis 7: schematische Darstellungen von Ausführungsbeispielen von hier beschriebenen Halbleiteranordnungen, und
- Figuren 3 und 8: ein Leadframe.

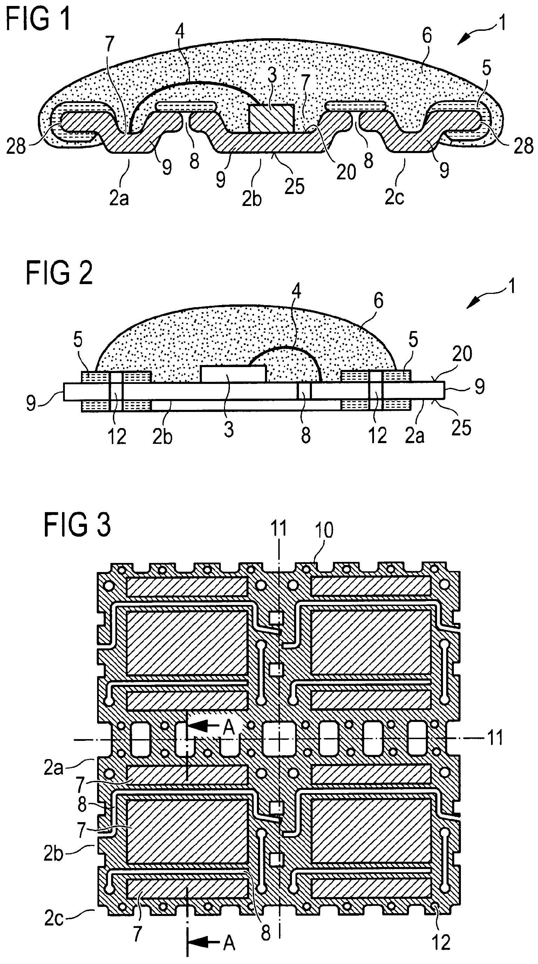

Figur 1 zeigt eine Halbleiteranordnung 1 im Querschnitt. Dabei ist eine Leiteranordnung 2 vorgesehen, die aus den drei Leiterabschnitten 2a, 2b und 2c besteht. Die einzelnen Abschnitte 2a, 2b, 2c sind durch Schlitze 8 getrennt. Auf dem Leiterabschnitt 2b ist ein Halbleiterelement 3, zum Beispiel eine Leuchtdiode, auch als LED bekannt, in einem Anschlussbereich 9 an einer Oberseite 20 der Leiteranordnung 2 befestigt und elektrisch leitend verbunden, zum Beispiel mittels Löten. Über einen Bond-Draht 4 ist die Leuchtdiode 3 mit dem Leiterabschnitt 2a elektrisch leitend verbunden. Die Leiterabschnitte 2b, 2c können einstückig ausgebildet sein.

Weiterhin ist ein Lötstopp 5 als Lötstoppschicht auf der Leiteranordnung 2 aufgetragen und eine Kapselmasse 6 kapselt die Diode 3 einschließlich der Bondverbindung des BondDrahtes 4 ein, wobei die Kapselmasse 6 derart aufgetragen ist, dass sie am Rand der Halbleiteranordnung 1 auf dem Lötstopplack 5 aufliegt. Hiermit ist eine Erhöhung der Haltekraft der Kapselmasse 6 ermöglicht.

Damit die Leiteranordnung 2 gut auf Platinenkontakten, die hier nicht dargestellt sind, angelötet werden kann, wird das als Ausgangsmaterial für die Leiteranordnung 2 verwendete Kupferblech insbesondere nacheinander mit Nickel, Palladium und Gold beschichtet. Ebenso ist ein punktuelles Beschichten mit Silber, ein so genanntes Ag-Spot-Plating, möglich.

Insbesondere dann, wenn als Halbleiterelement 3 eine Leuchtdiode verwendet wird, das eine transparente, klare Verkapselung erfordert, wird ein Silikon, ein Epoxid oder ein Silkon-Epoxid-Hybridmaterial als Kapselmasse 6 eingesetzt. Damit diese Kapselmasse 6 an der Leiteranordnung 2 einen besseren Halt findet, wird die Verkapselung, wie in Figur 1 dargestellt, um Stirnflächen 28 der Leiteranordnung 2 von der Oberseite 20 auf eine dem Halbleiterelement 3 gegenüberliegende Unterseite 25 der Leiteranordnung 2 herum geführt, ebenso wie die Lötstoppschicht 5. Die Schlitze 8 sind jedoch von der Lötstoppschicht 5 vollständig überdeckt, so dass kein Material der Kapselmasse 6 in die Schlitze 8 dringt.
Da, wie in Figur 1 dargestellt ist, die Lötstoppschicht 5 auch auf der dem Halbleiterelement 3 abgewandten Unterseite 25 der Leiteranordnung 2 aufgetragen ist, ergibt sich eine ausreichend große Adhäsion mit der Kapselmasse 6, so dass am Rand der Kapselmasse 6 sich keine Öffnung zwischen der Kapselmasse 6 und der Leiteranordnung 2 und/oder der Lötstoppschicht 5 ausbildet. Eine Haftkraft, gerechnet pro Flächeneinheit, der Kapselmasse 6 an der Lötstoppschicht 5 übersteigt eine Haftkraft der Kapselmasse 6 unmittelbar an der Leiteranordnung 2 bevorzugt um mindestens einen Faktor 1,5, insbesondere um mindestens einen Faktor 2.
Damit die wie in Figur 1 gekapselte Leiteranordnung 2 mit Platinenanschlüssen verlötet werden kann, weist die Leiteranordnung 3, in einer Richtung senkrecht zu einer Haupterstreckungsrichtung der Leiteranordnung 3, über die Kapselmasse 6 überstehende Anschlussflächen 9 an der Unterseite 25 auf. Diese Anschlussflächen 9 entstehen durch Kaltverformung, wodurch den Anschlussflächen 9 gegenüberliegend Vertiefungen 7 an der Oberseite 20 der Leiteranordnung 2 entstehen. Diese Strukturgebung kann aber auch mittels Ätzen erfolgen. Anders als in Figur 1 dargestellt, ist es ebenso möglich, dass die Kapselmasse 6 und die Anschlussflächen 9 in Richtung senkrecht zur Haupterstreckungsrichtung der Leiteranordnung 3 und/oder in lateraler Richtung eben beziehungsweise bündig miteinander abschließen.

In Figur 2 ist ein weiteres Ausführungsbeispiel gezeigt, bei dem die Halbleiteranordnung 1 eine plane Leiteranordnung 2 aufweist. In diesem Ausführungsbeispiel ist die Kapselmasse 6 nur einseitig aufgetragen, so dass nur ein Teil der Oberseite 20 von der Kapselmasse 6 überdeckt ist und so dass die Unterseite 25 frei oder im Wesentlichen frei von der Kapselmasse 6 ist. Zum Beispiel ist die Unterseite 25 zu weniger als 25 % oder zu weniger als 10 % von der Kapselmasse 6 und/oder der Lötstoppschicht 5 bedeckt.

Teile der Leiteranordnung 2 stehen über die Kapselmasse 6 in lateraler Richtung an einem Rand der Leiteranordnung 2 über, um die Anschlussflächen 9 zu bilden. Die Kapselmasse 6 dringt in dem dargestellten Ausführungsbeispiel in Öffnungen 12 ein, damit sich die Kapselmasse 6 an der Leiteranordnung 2 verankert. Es ist möglich, dass die Kapselmasse 6 den Schlitz 8 und/oder die Öffnungen 12, die jeweils in den Leiterabschnitten 2a, 2b geformt sind, vollständig durchdringt und einen Teil der Unterseite 25 bedeckt.

In Figur 3 ist ein Leiterrahmenverbund 10 dargestellt, wobei die Leiteranordnung 2 aus diesem zum Beispiel durch Stanzen oder durch Sägen entlang von Trennlinien 11 herausgelöst ist. Die Querschnittsanordnung, die in Figur 1 dargestellt ist, ergibt sich entlang der Schnittlinie A/A, wobei in Figur 3 nur der Leiterrahmenverbund 10 ohne Halbleiterbauelemente und ohne Kapselmasse dargestellt ist. Verfolgt man die Trennlinien 11, so erkennt man, dass die Leiterabschnitte 2a und 2b etwa durch Herausstanzen entlang der Trennlinien 11 durch den Schlitz 8 voneinander isoliert sind. Die Bereiche 2c und 2b sind jedoch durch dieses Heraustrennen weiterhin über einzelne Abschnitte miteinander verbunden.

Nunmehr wird ein Beispiel eines Herstellungsverfahrens der in Figur 1 und 2 dargestellten Halbleiteranordnung 1 beschrieben. Es wird ein Leiterrahmen 2, wie er in der Ansicht gemäß Figur 3 dargestellt ist, zur Verfügung gestellt. Dabei werden zunächst aus einem Blechmaterial die dargestellten Schlitze 8 und Öffnungen 12 ausgestanzt beziehungsweise herausgeätzt. Das Blechmaterial umfasst oder besteht aus Kupfer und ist bevorzugt mit Nickel, Palladium und Gold beschichtet. Diese Beschichtung kann vor oder nach dem Ausbilden der Form des Leiterrahmenverbunds 10 erfolgen. Darüber hinaus werden Bereiche 7 und 9 gemäß Figur 1 entweder durch Kaltverformung oder durch Ätzen ausgebildet.

Anschließend wird ein Lötstopplack im schraffierten Bereich aufgetragen und so die Lötstoppschicht 5 geformt. Alternativ kann die Lötstoppschicht 5 auch vor dem Beschichten des Leiterrahmenverbunds 10 erfolgen. Dann steht ein Material der Lötstoppschicht 5 in unmittelbarem Kontakt mit einem Material des Leiterrahmenverbunds 10, zum Beispiel Kupfer. Eine Haftung der Lötstoppschicht 5 an Kupfer ist höher als an der Beschichtung, insbesondere als an Gold. Insbesondere wenn der Leiterrahmenverbund 10 Hinterschneidungen aufweist, wird die Lötstoppschicht 5 von beiden Seiten des Leiterrahmenverbunds 10 her, zum Beispiel über ein zweiseitiges Siebdruckverfahren aufgebracht.

Danach wird das Halbleiterelement 3 im Leiterabschnitt 2b in der Vertiefung 7 befestigt und elektrisch leitend mit dem Abschnitt 2b verbunden. Sodann wird eine Bondverbindung mittels des Bonddrahtes 4 zwischen dem Halbleiterelement 3 und der Vertiefung 7 in dem Leiterabschnitt 2a ausgebildet. Schließlich wird die Kapselmasse 6 aufgetragen. Wird danach entlang der Trennlinien 11 durch Trennen, Sägen, Ätzen oder Schneiden die Halbleiteranordnung 1 aus dem in Figur 3 dargestellten Leiterrahmenverbund 10 herausgetrennt, fallen die Leiterabschnitte 2a und 2c nicht auseinander, da sie über die Kapselmasse 6 zusammengehalten werden.

Wird sodann die in Figur 1 dargestellte Halbleiteranordnung 1 mit den Anschlussflächen 9 auf einer nicht gezeichneten Platine aufgesetzt und verlötet, verhindert der Lötstopplack 5, dass das Lötzinn unter die Kapselmasse, insbesondere zwischen die Kapselmasse 6 und den Leiterrahmen 2, eindringt. Ein solches Eindringen kann, wenn keine Lötstoppschicht 5 vorliegt, durch Kapillarkräfte verstärkt sein.

Ein weiteres vorteilhaftes Ergebnis ist durch die Verwendung des Lötstopplackes dadurch gegeben, dass die Auswahl einer bestimmten Farbe für den Lötstopplack die farbliche Gestaltung der Halbleiteranordnung 1 auch dann bestimmt ist, wenn die Kapselmasse 6 klar transparent ist. Durch eine schwarze Lötstoppschicht 5 ist zum Beispiel ein Kontrast einer von der Halbleiteranordnung 1 emittierten Strahlung erhöhbar. Mit einer weißen Lötstoppschicht 5 kann eine Auskoppeleffizienz von Strahlung aus der Kapselmasse 6 heraus gesteigert werden. Auch kann die Lötstoppschicht 5 transparent oder diffus streuend ausgestaltet sein.

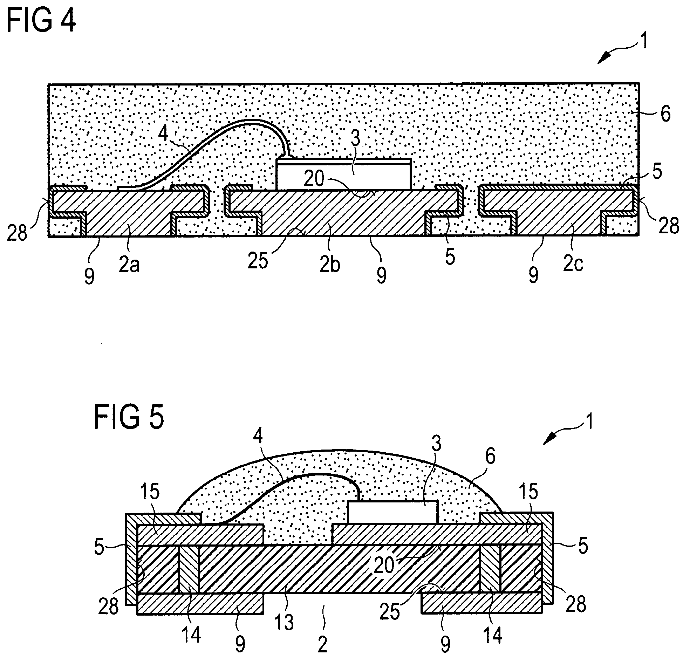

Bei der in Figur 4 dargestellten Anordnung handelt es sich um eine weitere Ausgestaltung des Ausführungsbeispiels gemäß Figur 2. Auch hier ist das Halbleiterelement 3 auf einem Leiterabschnitt 2b angeordnet und mit dem Leiterabschnitt 2a über den Bond-Draht 4 elektrisch leitend verbunden. Zusammen mit dem Abschnitt 2c sind die drei Abschnitte, die zusammen die Leiteranordnung 2 bilden, von der Kapselmasse 6 fast vollständig umgeben. Es sind alleine die Anschlussflächen 9, wie in Figur 4 dargestellt, frei. Optional können auch die Stirnflächen 28, die die Leiteranordnung 2 in lateraler Richtung begrenzen, frei von der Kapselmasse 6 sein, beispielsweise bedingt durch einen Vereinzelungsprozess.
Auch hier ist bevorzugt an allen Flächen der Leiteranordnung 2, die nicht zu einer Kontaktierung des Halbleiterelements 3 oder zu einer externen Kontaktierung benötigt werden, die Lötstoppschicht 5 aufgetragen, die für eine gute Haftung der Kapselmasse 6 an der Leiteranordnung 2 sorgt und ein Eindringen von Lötmittel zwischen der Kapselmasse 6 und der Leiteranordnung 2 verhindert. Optional können die lateral außen liegenden Stirnseiten 28 von der Lötstoppschicht 5 unbedeckt sein, anders als in Figur 4 dargestellt.

In Figur 5 ist ein Vergleichsbeispiel dargestellt. Bei diesem Beispiel weist die Leiteranordnung 2 einen Träger 13 und beidseitig Anschlussflächen 9 und 15 auf. Die inneren Anschlussflächen 15 stellen das Kontaktpad für das Halbleiterelement 3, auch hier zum Beispiel eine LED, und das Bondpad bereit, auf dem der vom Halbleiterelement 3 kommende Bond-Draht 4 befestigt ist. Über Durchgangsverbindungen 14 sind die inneren Anschlussflächen 15 mit den Anschlussflächen 9 elektrisch leitend verbunden. Grundsätzlich könnte davon ausgegangen werden, dass der Träger 13, der in diesem Beispiel aus einem Kunststoffmaterial besteht, an den Stirnflächen 28 ein Heraufkriechen von Lötmaterial beim Anlöten der Anschlussflächen 9 verhindert. Die beschriebene Leiteranordnung 2 gemäß diesem Ausführungsbeispiel wird jedoch beim Vereinzeln gesägt. Beim Sägen kann es geschehen, dass leitendes Material der Anschlussflächen 9 und/oder 15 an die Stirnflächen 28 gelangt, was wiederum die Gefahr aufkommen lässt, dass Lötmaterial bis an die Kapselmasse 6 gelangt. Daher ist es auch in diesem Beispiel vorteilhaft, dass, wie dargestellt, eine Lötstoppschicht insbesondere über den Stirnflächen 28 der Leiteranordnung aufgetragen ist. Weiterhin sorgt auch in diesem Beispiel die Lötstoppschicht 5 für ein besseres Halten der Kapselmasse 6 auf den inneren Anschlussflächen 15.

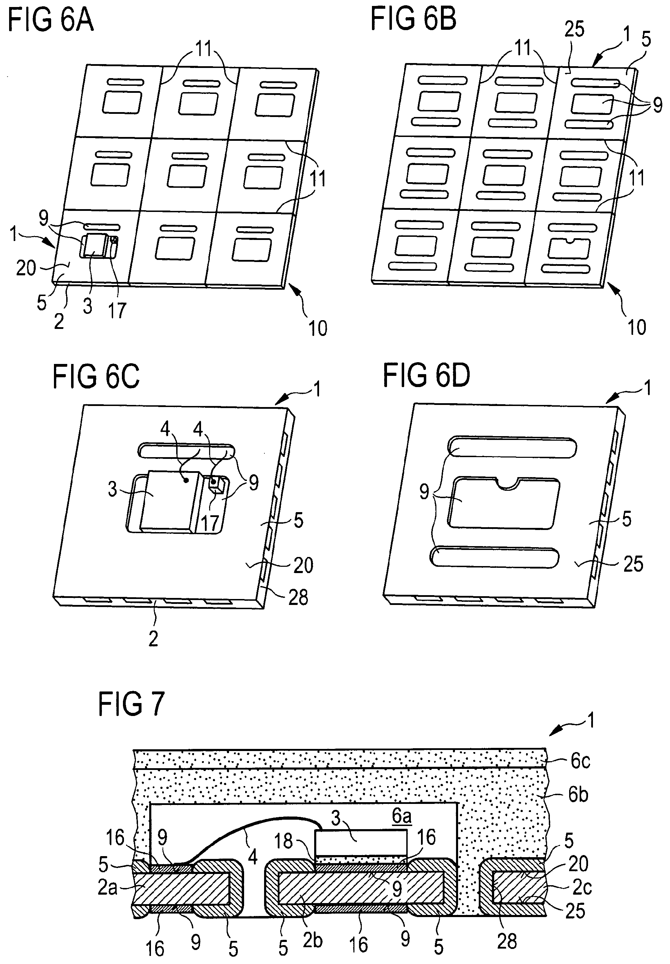

Die Herstellung dieses Beispiels erfolgt analog zum Herstellungsverfahren, wie es unter Bezugnahme auf das Ausführungsbeispiel gemäß Figur 1 beschrieben ist. In den Figuren 6C ist eine schematische Draufsicht und in Figur 6D eine schematische Unteransicht eines weiteren Ausführungsbeispiels des Halbleiteranordnung jeweils perspektivisch dargestellt. In den Figuren 6A und 6B sind perspektivisch eine Draufsicht und eine Unteransicht des zugrundeliegenden Leadframes beziehungsweise des zugrunde liegenden Leiterrahmenverbundes 10 gezeigt.
In Figur 6 sind die einzelnen Leiterabschnitte der Leiteranordnung 2 nicht gezeichnet, ebenso wenig wie die Kapselmasse. An der Oberseite 20 jeder der Leiteranordnungen 2 befinden sich zwei der Anschlussflächen 9, an der Unterseite 25 jeweils drei der Anschlussflächen 9. Jede der Anschlussflächen 9 ist vollständig von der Lötstoppschicht 5 eingefasst. An der Oberseite 20 sind auf der gemeinsamen ersten Anschlussfläche 9 sowohl das Halbleiterelement 3 als auch ein Schutzbauteil 17 gegen Schäden aufgrund elektrostatischer Aufladung angebracht. Bei dem Schutzbauteil 17 kann es sich ebenfalls um eine Leuchtdiode handeln.

Mit der zweiten Anschlussfläche 9 auf der Oberseite 20 ist zu dem Halbleiterelement 3 beziehungsweise zu dem Schutzbauteil 17 eine elektrische Verbindung über die Bond-Drähte 4 hergestellt. Die Bond-Drähte 4 werden zum Beispiel über ein Reibschweißverfahren befestigt. Durch die Umfassung der Anschlussflächen 9 mit der Lötstoppschicht 5 sind die Bond-Drähte 4 dauerhaft vor physischem Kontakt mit einem nicht dargestellten Lötzinn, mit dem die Halbleiteranordnung 1 über die Unterseite 25 etwa an einer nicht gezeichneten Leiterplatte befestigt ist, geschützt. Damit ist auch eine Versprödung oder ein Bruch der Bond-Drähte 4 verhinderbar.

Beim weiteren Ausführungsbeispiel der Halbleiteranordnung 1, siehe die Schnittdarstellung in Figur 7, sind die Leiterabschnitte 2b, 2c mit dem Leiterabschnitt 2a mechanisch über die mehreren Lagen der Kapselmassen 6a, 6b, 6c verbunden. Die Kapselmassen 6a, 6b, 6c basieren oder beinhalten zum Beispiel ein Silikon und insbesondere eine oder mehrere Beimengungen in Form von Diffusionsmitteln, Konversionsmitteln zu einer Wellenlängenkonversion, Filtermitteln, Mitteln zur Steigerung der thermischen Leitfähigkeit oder zur Anpassung eines thermischen Ausdehnungskoeffizienten und/oder Härtemitteln. Zum Beispiel ist der das Halbleiterelement 3 unmittelbar umgebenden und umschließenden Kapselmasse 6a ein Konversionsmittel, der durchgehenden Kapselmasse 6b ein Mittel zur Absorption oder Reflexion von ultravioletter Strahlung und der schichtförmigen Kapselmasse 6c ein Härtemittel zur Steigerung etwa einer Kratzfestigkeit beigegeben. Ebenso können die Kapselmassen 6a, 6b, 6c auf voneinander verschiedenen Materialien basieren. Die Kapselmasse 6a beschränkt sich in lateraler Richtung im Wesentlichen auf die Anschlussflächen 9, die Kapselmassen 6b, 6c überdecken die gesamte Oberseite 20.

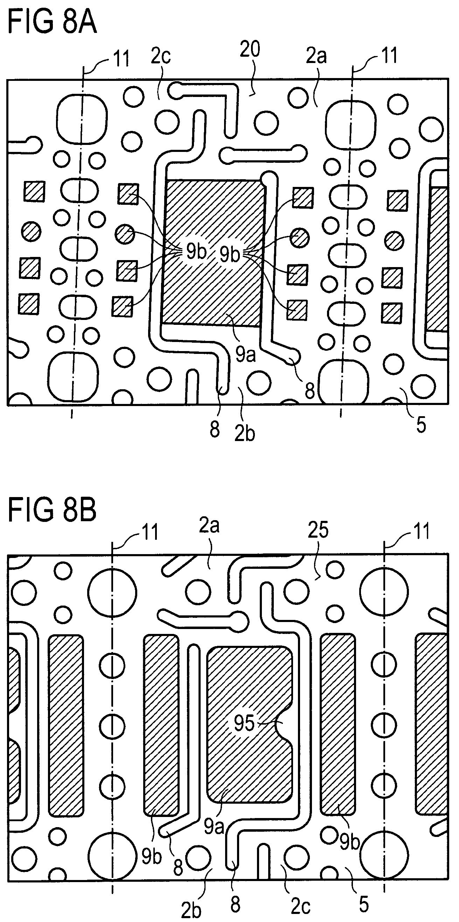

In Figur 8A ist eine Draufsicht und in Figur 8B eine Unteransicht eines weiteren Ausführungsbeispiels eines Leadframes gezeigt. An der Oberseite 20 ist eine Mehrzahl von Anschlussflächen 9b ausgebildet, wobei jeweils mehrere der Anschlussflächen 9b an der Oberseite 20 zu einer einzigen, korrespondierenden Anschlussfläche 9b an der Unterseite 25 zusammengefasst sind. Insbesondere zu einer Markierung der Montagerichtung auf zum Beispiel einer nicht gezeichneten Leiterplatte weist die Anschlussfläche 9a an der Unterseite 25 eine zum Beispiel farblich gestaltete Markierung in Form einer Einbuchtung 95 der Lötstoppschicht 5 in die Anschlussfläche 9a auf, siehe auch Figur 6D. Die Trennlinien 11 queren jeweils eine Mehrzahl von Durchbrüchen beziehungsweise Öffnungen durch den Leadframe.
Die Erfindung ist nicht durch die Beschreibung anhand der Ausführungsbeispiele auf diese beschränkt. Vielmehr ist die Erfindung nur durch die Patentansprüche begrenzt.
Diese Patentanmeldung beansprucht die Priorität der deutschen Patentanmeldung 10 2009 008 738.9 .

## Patentansprüche

1. Halbleiteranordnung (1) mit
- zumindest einer aus einem metallischen, blechförmigen Halbzeug gefertigten Leiteranordnung (2) mit einer Oberseite (20) und mit einer der Oberseite (20) gegenüberliegenden Unterseite (25), wobei die Leiteranordnung (2) mindestens zwei jeweils voneinander elektrisch isolierte Abschnitte (2a, 2b, 2c) aufweist,
- mindestens einer Lötstoppschicht (5), die die Oberseite (20) und die Unterseite (25) jeweils teilweise bedeckt, wobei wenigstens Teilbereiche der Oberseite (20) und der Unterseite (25), die nicht von der Lötstoppschicht (5) bedeckt sind, elektrische Anschlussflächen (9) bilden,
- einem optoelektronischen Halbleiterelement (3), das auf der Oberseite (20) der Leiteranordnung (2) auf wenigstens einer der Anschlussflächen (9) befestigt und mit dieser elektrisch leitend verbunden ist, wobei das Halbleiterelement (3) auf einem der Abschnitte (2b) angebracht und über ein elektrisch leitendes Verbindungselement (4) mit wenigstens einem anderen der Abschnitte (2a, 2c) elektrisch leitend verbunden ist, und
- einer strahlungsdurchlässigen Kapselmasse (6), die wenigstens an der Oberseite (20) der Leiteranordnung (2) aufgebracht ist, wobei die Kapselmasse (6) das Halbleiterelement (3) abdeckt und zumindest teilweise an der Lötstoppschicht (5) anliegt und eine mechanische Verbindung zwischen den Abschnitten (2a, 2b, 2c) über die Kapselmasse (6) gegeben ist,,
und wobei die Anschlussflächen (9) jeweils vollständig von der Lötstoppschicht (5) umrandet sind.

2. Halbleiteranordnung (1) nach dem vorhergehenden Anspruch,
wobei die Leiteranordnung (2) zumindest eine Vertiefung (7) aufweist, in der das Halbleiterelement (3) befestigt ist.

3. Halbleiteranordnung (1) nach einem der vorhergehenden Ansprüche,
wobei die Anschlussflächen (9) der Unterseite (25) nicht von der Kapselmasse (6) überdeckt sind.

4. Halbleiteranordnung (1) nach einem der vorhergehenden Ansprüche,
bei der um jede der Anschlussflächen (9) herum an einer Oberfläche der Leiteranordnung (2) ein geschlossener Pfad eines Materials der Lötstoppschicht (5) existiert, wobei der geschlossene Pfad sich jeweils vollständig an der Oberseite (20) oder an der Unterseite (25) der Leiteranordnung (2) befindet.

5. Halbleiteranordnung (1) nach dem vorhergehenden Anspruch,
bei der die mindestens zwei Abschnitte (2a, 2b, 2c) mittels eines Schlitzes (8) voneinander getrennt sind.

6. Halbleiteranordnung (1) nach einem der vorhergehenden Ansprüche,
bei der die Unterseite (25) zu weniger als 10 % von der Kapselmasse (6) und von der Lötstoppschicht (5) bedeckt ist.

7. Halbleiteranordnung (1) nach einem der vorhergehenden Ansprüche,
bei der die Lötstoppschicht (5) zumindest stellenweise in einem Querschnitt U-förmig ausgebildet ist, so dass sich die Lötstoppschicht (5) über Stirnseiten (28) der Leiteranordnung (2) hinweg erstreckt und als durchgehende Schicht von der Oberseite (20) bis zur Unterseite (25) reicht.

8. Halbleiteranordnung (1) nach einem der vorhergehenden Ansprüche,
bei der die Lötstoppschicht (5) aus einem Lötstopplack besteht.

9. Halbleiteranordnung (1) nach einem der vorhergehenden Ansprüche,
die sowohl an der Oberseite (20) als auch an der Unterseite (25) mindestens zwei der Anschlussflächen (9) aufweist.

10. Halbleiteranordnung nach einem der vorhergehenden Ansprüche, bei der das Verbindungselement (4) ein Bond-Draht (4) ist.

11. Halbleiteranordnung (1) nach einem der vorhergehenden Ansprüche,
bei der das zumindest eine Halbleiterelement (3) eine Leuchtdiode, eine Laserdiode oder eine Photodiode ist.

12. Verfahren zum Herstellen einer Halbleiteranordnung (1) nach einem der vorigen Ansprüche, bei dem
- eine Leiteranordnung (2) mit einer Oberseite (20) und mit einer dieser gegenüberliegenden Unterseite (25) zur Verfügung gestellt wird,
- auf der Oberseite (20) und auf der Unterseite (25) der Leiteranordnung (2) wenigstens eine Lötstoppschicht (5) zumindest teilweise aufgetragen wird, wobei wenigstens Teilbereiche der Oberseite (20) und der Unterseite (25), die nicht von der Lötstoppschicht (5) bedeckt werden, elektrische Anschlussflächen (9) bilden,
- ein optoelektronisches Halbleiterelement (3) an der Oberseite (20) der Leiteranordnung (2) auf einer der Anschlussflächen (9) angeordnet und mit der Leiteranordnung (2) elektrisch leitend verbunden wird, und
- mittels einer Kapselmasse (6) das Halbleiterbauelement (3) auf der Leiteranordnung (2) derart gekapselt wird, dass die Kapselmasse (6) zumindest teilweise mit der Lötstoppschicht (5) in mechanischem Kontakt steht, wobei die Anschlussflächen (9) jeweils vollständig von der Lötstoppschicht (5) umrandet werden.

13. Verfahren nach dem vorhergehenden Anspruch,
bei dem die Leiteranordnung (2) als Teil eines metallisch blechernen Halbzeugs bereitgestellt und die Lötstoppschicht (5) aufgetragen wird, bevor die Leiteranordnung (2) aus dem Halbzeug herausgetrennt wird.

14. Verfahren nach Anspruch 12 oder 13,
bei dem nach dem Auftragen der Lötstoppschicht (5) die Anschlussflächen (9) jeweils mit mindestens einer metallischen Schicht (16) versehen werden,
wobei von der Lötstoppschicht (5) überdeckte Bereiche der Oberseite (20) und der Unterseite (25) von der metallischen Schicht (16) unbedeckt bleiben.

15. Verfahren nach einem der Ansprüche 12 bis 14,
bei dem die Lötstoppschicht (5) strukturiert aufgebracht und anschließend ausgehärtet und/oder getrocknet wird, wobei nach dem Aushärten oder Trocknen die Lötstoppschicht (5) vollständig an der Oberseite (20) und an der Unterseite (25) der Leiteranordnung (2) verbleibt.

## Claims

1. Semiconductor arrangement (1) comprising
- at least one conductor arrangement (2) having a top side (20) and having an underside (25) situated opposite the top side (20), said at least one conductor arrangement being produced from a metallic, sheet-shaped semifinished product, wherein the conductor arrangement (2) has at least two sections (2a, 2b, 2c) which are respectively electrically insulated from one another,
- at least one solder resist layer (5) which in each case partly covers the top side (20) and the underside (25), wherein at least partial regions of the top side (20) and of the underside (25) which are not covered by the solder resist layer (5) form electrical connection areas (9),
- an optoelectronic semiconductor element (3), which is fixed on the top side (20) of the conductor arrangement (2) on at least one of the connection areas (9) and is electrically conductively connected thereto, wherein the semiconductor element (3) is fitted on one of the sections (2b) and is electrically conductively connected to at least one other of the sections (2a, 2c) by an electrically conductive connecting element (4), and
- a radiation-transmissive encapsulation compound (6) applied at least at the top side (20) of the conductor arrangement (2), wherein the encapsulation compound (6) covers the semiconductor element (3) and at least partly bears against the solder resist layer (5), and a mechanical connection between the sections (2a, 2b, 2c) is provided via the encapsulation compound (6),
and wherein the connection areas (9) are bordered in each case completely by the solder resist layer (5).

2. Semiconductor arrangement (1) according to the preceding claim,
wherein the conductor arrangement (2) has at least one depression (7) in which the semiconductor element (3) is fixed.

3. Semiconductor arrangement (1) according to either of the preceding claims,
wherein the connection areas (9) of the underside (25) are not covered by the encapsulation compound (6).

4. Semiconductor arrangement (1) according to any of the preceding claims,
wherein a closed path of a material of the solder resist layer (5) exists around each of the connection areas (9) at a surface of the conductor arrangement (2), wherein the closed path is situated in each case completely at the top side (20) or at the underside (25) of the conductor arrangement (2).

5. Semiconductor arrangement (1) according to the preceding claim,
wherein the at least two sections (2a, 2b, 2c) are separated from one another by means of a slot (8).

6. Semiconductor arrangement (1) according to any of the preceding claims,
wherein the underside (25) is covered by the encapsulation compound (6) and by the solder resist layer (5) to the extent of less than 10%.

7. Semiconductor arrangement (1) according to any of the preceding claims,
wherein the solder resist layer (5) is embodied in a U-shaped fashion in a cross section at least in places, such that the solder resist layer (5) extends across end sides (28) of the conductor arrangement (2) and extends as a continuous layer from the top side (20) as far as the underside (25).

8. Semiconductor arrangement (1) according to any of the preceding claims,
wherein the solder resist layer (5) consists of a solder resist.

9. Semiconductor arrangement (1) according to any of the preceding claims,
which has at least two of the connection areas (9) both at the top side (20) and at the underside (25).

10. Semiconductor arrangement according to any of the preceding claims,
wherein the connecting element (4) is a bonding wire (4).

11. Semiconductor arrangement (1) according to any of the preceding claims,
wherein the at least one semiconductor element (3) is a light-emitting diode, a laser diode or a photodiode.

12. Method for producing a semiconductor arrangement (1) according to any of the preceding claims, wherein
- a conductor arrangement (2) having a top side (20) and having an underside (25) situated opposite said top side is made available,
- at least one solder resist layer (5) is at least partly applied on the top side (20) and on the underside (25) of the conductor arrangement (2), wherein at least partial regions of the top side (20) and of the underside (25) which are not covered by the solder resist layer (5) form electrical connection areas (9),
- an optoelectronic semiconductor element (3) is arranged at the top side (20) of the conductor arrangement (2) on one of the connection areas (9) and is electrically conductively connected to the conductor arrangement (2), and
- by means of an encapsulation compound (6) the semiconductor element (3) on the conductor arrangement (2) is encapsulated in such a way that the encapsulation compound (6) is at least partly in mechanical contact with the solder resist layer (5),
wherein the connection areas (9) are bordered in each case completely by the solder resist layer (5).

13. Method according to the preceding claim,
wherein the conductor arrangement (2) is provided as part of a metallically sheetlike semifinished product and the solder resist layer (5) is applied before the conductor arrangement (2) is separated from the semifinished product.

14. Method according to Claim 12 or Claim 13, wherein, after the solder resist layer (5) has been applied, the connection areas (9) are provided in each case with at least one metallic layer (16),
wherein regions of the top side (20) and of the underside (25) that are covered by the solder resist layer (5) continue not to be covered by the metallic layer (16).

15. Method according to any of Claims 12 to 14,
wherein the solder resist layer (5) is applied in a structured fashion and is subsequently cured and/or dried,
wherein after curing or drying the solder resist layer (5) remains completely at the top side (20) and at the underside (25) of the conductor arrangement (2).

## Revendications

1. Arrangement semiconducteur (1) comprenant
- au moins un arrangement conducteur (2) fabriqué à partir d'un produit semi-fini métallique en forme de tôle, pourvu d'un côté supérieur (20) et d'un côté inférieur (25) opposé au côté supérieur (20), l'arrangement conducteur (2) possédant au moins deux portions (2a, 2b, 2c) respectivement isolées électriquement l'une de l'autre,
- au moins une couche de blocage de brasure (5) qui recouvre respectivement partiellement le côté supérieur (20) et le côté inférieur (25), au moins des zones partielles du côté supérieur (20) et du côté inférieur (25) qui ne sont pas recouvertes par la couche de blocage de brasure (5) formant des surfaces de raccordement électriques (9),
- un élément semiconducteur optoélectronique (3) qui est fixé sur le côté supérieur (20) de l'arrangement conducteur (2) sur au moins l'une des surfaces de raccordement (9) et qui est relié de manière électriquement conductrice avec celui-ci, l'élément semiconducteur (3) étant monté sur l'une des portions (2b) et étant relié de manière électriquement conductrice à au moins une autre des portions (2a, 2c) par le biais d'un élément de liaison (4) électriquement conducteur, et
- une masse d'enrobage (6) laissant passer le rayonnement, laquelle est appliquée au moins sur le côté supérieur (20) de l'arrangement conducteur (2), la masse d'enrobage (6) recouvrant l'élément semiconducteur (3) et reposant au moins partiellement sur la couche de blocage de brasure (5) et une liaison mécanique entre les portions (2a, 2b, 2c) étant réalisée par le biais de la masse d'enrobage (6),
et les surfaces de raccordement (9) étant respectivement entièrement entourées par la couche de blocage de brasure (5).

2. Arrangement semiconducteur (1) selon la revendication précédente, avec lequel l'arrangement conducteur (2) possède au moins une cavité (7) dans laquelle est fixé l'élément semiconducteur (3).

3. Arrangement semiconducteur (1) selon l'une des revendications précédentes, avec lequel les surfaces de raccordement (9) du côté inférieur (25) ne sont pas recouvertes par la masse d'enrobage (6).

4. Arrangement semiconducteur (1) selon l'une des revendications précédentes, avec lequel il existe autour de chacune des surfaces de raccordement (9), sur une surface de l'arrangement conducteur (2), un chemin fermé d'un matériau de la couche de blocage de brasure (5), le chemin fermé se trouvant respectivement entièrement sur le côté supérieur (20) ou sur le côté inférieur (25) de l'arrangement conducteur (2).

5. Arrangement semiconducteur (1) selon l'une des revendications précédentes, avec lequel les au moins deux portions (2a, 2b, 2c) sont séparées l'une de l'autre au moyen d'une fente (8).

6. Arrangement semiconducteur (1) selon l'une des revendications précédentes, avec lequel le côté inférieur (25) est recouvert à moins de 10 % par la masse d'enrobage (6) et par la couche de blocage de brasure (5).

7. Arrangement semiconducteur (1) selon l'une des revendications précédentes, avec lequel la couche de blocage de brasure (5) est au moins à certains endroits réalisée avec une section transversale en forme de U, de sorte que la couche de blocage de brasure (5) s'étend au-delà des côtés frontaux (28) de l'arrangement conducteur (2) et s'étire du côté supérieur (20) jusqu'au côté inférieur (25).

8. Arrangement semiconducteur (1) selon l'une des revendications précédentes, avec lequel la couche de blocage de brasure (5) se compose d'un vernis de blocage de brasure.

9. Arrangement semiconducteur (1) selon l'une des revendications précédentes, lequel possède au moins deux surfaces de raccordement (9) à la fois sur le côté supérieur (20) et sur le côté inférieur (25).

10. Arrangement semiconducteur selon l'une des revendications précédentes, avec lequel l'élément de liaison (4) est un fil de connexion (4).

11. Arrangement semiconducteur (1) selon l'une des revendications précédentes, avec lequel l'au moins un élément semiconducteur (3) est une diode électroluminescente, une diode laser ou une photodiode.

12. Procédé de fabrication d'un arrangement semiconducteur (1) selon l'une des revendications précédentes, selon lequel
- un arrangement conducteur (2) pourvu d'un côté supérieur (20) et d'un côté inférieur (25) opposé à celui-ci est produit
- au moins une couche de blocage de brasure (5) est appliquée au moins partiellement sur le côté supérieur (20) et sur le côté inférieur (25) de l'arrangement conducteur (2), au moins des zones partielles du côté supérieur (20) et du côté inférieur (25) qui ne sont pas recouvertes par la couche de blocage de brasure (5) formant des surfaces de raccordement électriques (9),
- un élément semiconducteur optoélectronique (3) est disposé sur le côté supérieur (20) de l'arrangement conducteur (2) sur l'une des surfaces de raccordement (9) et relié de manière électriquement conductrice avec l'arrangement conducteur (2), et
- l'élément semiconducteur (3) est enrobé sur l'arrangement conducteur (2) au moyen d'une masse d'enrobage (6) de telle sorte que la masse d'enrobage (6) est au moins partiellement en contact mécanique avec la couche de blocage de brasure (5), les surfaces de raccordement (9) étant respectivement entièrement entourées par la couche de blocage de brasure (5).

13. Procédé selon la revendication précédente, selon lequel l'arrangement conducteur (2) est produit sous la forme d'une partie d'un produit semi-fini laminé métallique et la couche de blocage de brasure (5) est appliquée avant que l'arrangement conducteur (2) soit séparé du produit semi-fini.

14. Procédé selon la revendication 12 ou 13, selon lequel, après l'application de la couche de blocage de brasure (5), les surfaces de raccordement (9) sont respectivement dotées d'au moins une couche métallique (16), les zones du côté supérieur (20) et du côté inférieur (25) qui sont recouvertes par la couche de blocage de brasure (5) restant non recouvertes par la couche métallique (16).

15. Procédé selon l'une des revendications 12 à 14, selon lequel la couche de blocage de brasure (5) est appliquée de manière structurée et ensuite durcie et/ou séchée, la couche de blocage de brasure (5) demeurant entièrement sur le côté supérieur (20) et sur le côté inférieur (25) de l'arrangement conducteur (2) après le durcissement ou le séchage.
